# EUROPEAN PATENT APPLICATION

(11) **EP 2 288 041 A2**
(43) Date of publication of application: **23.02.2011**
(21) Application number: 10173314.5
(22) Date of filing: 18.08.2010
(51) Int. Cl.: H04B 1/30

(54) **Direct conversion receiver**

(30) Priority: 18.08.2009 US 274612 P
(71) Applicant: Youngblood, Gerald, Austin TX 13091 (US)
(72) Inventor: Youngblood, Gerald, Austin TX 13091 (US)
(74) Representative: Eisenführ, Speiser & Partner

(57) **Abstract**

In accordance with at least one embodiment, apparatus providing a direct conversion receiver comprises a phase sampling detector (e.g., a quadrature sampling detector), which comprises a leading phase operational amplifier subsystem and a leading phase analog switch, as well as a lagging phase operational amplifier subsystem and a lagging phase analog switch. In accordance with at least one embodiment, a leading phase analog switch output terminal is coupled to a first leading phase operational amplifier input of the leading phase operational amplifier subsystem, and the leading phase analog switch output terminal is maintained continually at a ground potential. In accordance with at least one embodiment, at least one of element selected from a group consisting of: a resistor feedback switch, a commutating input switch in a resistive feedback loop, a differential capacitor, an unbiased analog switch input terminal, and an unbiased analog switch output terminal is provided.

## Description

### CROSS-REFERENCE TO RELATED APPLICATIONS

This application claims the benefit of U.S. Provisional Application No. 61/274,612, filed August 18, 2009.

### BACKGROUND OF THE INVENTION

### (1) Field of the Invention

This invention relates to the general field of wireless communications and more specifically, the conversion of signals in frequency.

### (2) Description of the Related Art

Direct conversion (DC) or homodyne radio receivers have been well known for decades and are widely used in modern day communications systems. However, simple direct conversion receivers suffer from the lack of opposite sideband ("image") suppression when the signal is mixed to direct current (DC) (i.e., zero Hertz). This problem results from the signal of interest and the image products being superimposed in the baseband output. Image reject mixers have been used in an attempt to address the image problem associated with simple direct conversion mixers. The image rejection provided by analog phasing networks in conjunction an image reject mixer is limited, which limits overall performance of receivers based on such technology.

A history and description of the aforementioned direct conversion architectures are found in the 2003 book Experimental Methods in RF Design by Wes Hayward, Rick Campbell, and Bob Larkin. Rick Campbell also described in detail the operation and mathematics of image reject mixers for direct conversion receivers in an article titled, "High Performance, Single-Signal Direct-Conversion Receivers" in the January, 1993 issue of QST magazine, published by the American Radio Relay League (ARRL), 225 Main Street, Newington, CT 06111-1494.

Image reject mixers may be constructed using a complex arrangement of two separate mixer elements and two local oscillators phase shifted by 90 degrees from one another. An alternate quadrature sampling image rejection mixer was described by D. H. van Graas in an article titled, "The Fourth Method: Generating and Detecting SSB Signals" in the September 1990 issue of QEX magazine, also published by the American Radio Relay League (ARRL), 225 Main Street, Newington, CT 06111-1494, wherein a switching multiplexer IC was used to provide sampled and integrated in-phase and quadrature outputs. Now commonly referred to as a "quadrature sampling detector," or "QSD," this method provides a simple means of implementing an image reject mixer that reduces conversion loss into the 1dB range.

Image rejection mixers that use individual mixers are complex in implementation and typically exhibit on the order of 7-8 dB of conversion loss. Such mixers typically require very high level local oscillator drive power to achieve large signal handling capability and have poor local oscillator to input port isolation. Further, their performance is very sensitive to output impedance variations and offer poor termination to the preceding analog stage.

The quadrature sampling detector method offers a potential solution to the conversion loss problem by sampling and integrating the signal over a fractional percentage of the signal of interest waveform period. The conversion loss in such designs is determined primarily by the sampling period, which is on the order of 1 dB when using a 25% sampling period. In theory, an impulse sampling period would yield a 0 dB conversion loss when using ideal components.

While addressing the conversion loss problem, image reject mixers using the quadrature sampling detector method as described by van Graas in the September 1990 QEX article and in United States Patent 6,230,000, issued to Tayloe, suffer from increasing noise figure and local oscillator radiation with frequency and poor impedance matching. To perform adequately above approximately 15-20 MHz, such designs have typically required prior stage radio frequency amplifiers that in turn limit total spurious free dynamic range and increase power consumption.

Further, existing quadrature sampling detectors require that a direct current voltage be applied to the analog switches to bias the switch into the linear on-resistance region. Since the input signal causes the FET source voltage to swing around the bias voltage, the gate to source voltage will in turn be modulated thus introducing distortion. Another disadvantage of applying bias to the analog switches is that any direct current offset voltage between the switches will increase local oscillator radiation. To offset gate to source modulation in existing quadrature sampling detectors, higher local oscillator power is required further increasing oscillator radiation and power dissipation.

Thus, existing quadrature sampling detectors exhibit shortcomings that are increasingly undesirable as expectations of performance of wireless devices continue to rise.

### BRIEF DESCRIPTION OF THE SEVERAL VIEWS OF THE DRAWINGS

The present invention may be better understood, and its features made apparent to those skilled in the art by referencing the accompanying drawings.

FIG. 1 is a block diagram illustrating an example of a direct conversion receiver in accordance with at least one embodiment.

FIG. 2 is a schematic diagram illustrating an example of a double balanced direct conversion receiver with switched feedback loop in accordance with at least one embodiment.

FIG. 3 is a schematic diagram illustrating an example of a direct conversion receiver in accordance with at least one embodiment.

FIG. 4 is a schematic diagram illustrating an example of a double balanced direct conversion receiver in accordance with at least one embodiment.

FIG. 5 is a schematic diagram illustrating an example of a double balanced direct conversion receiver with switched feedback loops in accordance with at least on embodiment.

FIG. 6 is a schematic diagram illustrating an example of a double balanced direct conversion receiver with switched feedback loop in accordance with at least one embodiment.

FIG. 7 is a schematic diagram illustrating an example of a single balanced direct conversion receiver in accordance with at least one embodiment.

FIG. 8 is a schematic diagram illustrating an example of a double balanced direct conversion receiver in accordance with at least one embodiment.

FIG. 9 is a schematic diagram illustrating an example of a single balanced direct conversion receiver with switched feedback loop in accordance with at least one embodiment.

FIG. 10 is a schematic diagram illustrating an example of a single balanced direct conversion receiver with switched feedback loop in accordance with at least one embodiment.

FIG. 11 is a block diagram illustrating an example of a phase sampling detector in accordance with at least one embodiment.

FIG. 12 is a schematic diagram illustrating an example of a direct conversion receiver in accordance with at least one embodiment.

FIG. 13 is a schematic diagram illustrating an example of a direct conversion receiver in accordance with at least one embodiment.

The use of the same reference symbols in different drawings indicates similar or identical items.

### DETAILED DESCRIPTION OF THE INVENTION

Apparatus is provided for a direct conversion receiver. In accordance with at least one embodiment, the apparatus providing the direct conversion receiver comprises a phase sampling detector (e.g., a Quadrature Sampling Detector), which comprises a leading phase operational amplifier subsystem and a leading phase analog switch, as well as a lagging phase operational amplifier subsystem and a lagging phase analog switch. In accordance with at least one embodiment, a leading phase analog switch output terminal is coupled to a first leading phase operational amplifier input of the leading phase operational amplifier subsystem, and the leading phase analog switch output terminal is maintained continually at a ground potential.

In accordance with at least one embodiment, a lagging phase analog switch output terminal is coupled to a first lagging phase operational amplifier input of the lagging phase operational amplifier subsystem, and the lagging phase analog switch output terminal is maintained continually at the ground potential. In accordance with at least one embodiment, the leading phase analog switch is adapted to obtain a leading phase sample and the lagging phase analog switch is adapted to obtain a lagging phase sample, wherein a nonzero phase offset exists between a leading phase of the leading phase sample and a lagging phase of the lagging phase sample.

In accordance with at least one embodiment, at least one of element selected from a group consisting of: a resistor feedback switch, a commutating input switch in a resistive feedback loop, a differential capacitor, an unbiased analog switch input terminal, and an unbiased analog switch output terminal is provided. In accordance with at least one embodiment, both the resistor feedback switch and the commutating input switch may be in the resistive feedback loop.

In accordance with at least one embodiment, a direct conversion receiver can provide simplicity of radio frequency (RF) to audio frequency (AF) conversion without the need for an intermediate frequency (IF). In accordance with at least one embodiment, a direct conversion receiver can avoid internal spurious responses. In accordance with at least one embodiment, a direct conversion receiver can provide high spurious free dynamic range. In accordance with at least one embodiment, a direct conversion receiver can provide very low distortion of a desired signal. In accordance with at least one embodiment, a direct conversion receiver can provide frequency range independence. In accordance with at least one embodiment, a direct conversion receiver can provide high selectivity baseband filtering performed at audio frequencies (AF) using active filters. In accordance with at least one embodiment, a direct conversion receiver can operate without the need for more than one local oscillator synthesizer. In accordance with at least one embodiment, a direct conversion receiver can be adapted to be highly compatible with digital-signal-processing-based (DSP-based) receiver architectures.

In accordance with at least one embodiment, improved performance is offered by an image reject mixer using the quadrature sampling detector for conversion of a signal to baseband. For example, in accordance with at least one embodiment, a simple, low power, and low cost means of implementing a high dynamic range, image reject mixer can be provided using commercially available components. In accordance with at least one embodiment, an image reject mixer can be provided wherein switching elements operate at direct current ("virtual") ground potential and/or within an operational amplifier feedback loop in order to minimize distortion due to modulation of the on resistance of the solid state switch. In accordance with at least one embodiment, an image reject mixer can be provided wherein the maximum signal voltage applied across the switching element is less than 10% of the signal at the mixer input without a corresponding increase in mixer noise figure. In accordance with at least one embodiment, an image reject mixer can be provided that reduces conversion loss while at the same time maintaining the switches at direct current, virtual ground potential as described above. In accordance with at least one embodiment, an image reject mixer can be provided that exhibits low distortion with the use of very low power local oscillator drive. In accordance with at least one embodiment, an image reject mixer can be provided wherein low local oscillator power drive reduces charge injection to the switching elements thus minimizing receiver noise figure with increasing frequency. In accordance with at least one embodiment, an image reject mixer can be provided wherein both gain of the mixer may be adjusted simply by changing the value of the resistive element in the feedback loop. In accordance with at least one embodiment, an image reject mixer can be provided that functions as a high-Q tracking filter in which its bandwidth is determined by the time constant of a parallel resistor and capacitor network. In accordance with at least one embodiment, an image reject mixer can be provided that meets governing body electromagnetic emissions standards for local oscillator radiation without the need for isolation amplifiers in the preceding stages. In accordance with at least one embodiment, an image reject mixer can be provided wherein its input resistively terminates the prior analog stage at its characteristic impedance. In accordance with at least one embodiment, an image reject mixer can be provided in which the sampling capacitor reactance is not reflected back into the mixer input. In accordance with at least one embodiment, an image reject mixer can be provided that can be effectively implemented in a low power integrated circuit. In accordance with at least one embodiment, a simple and elegant image reject mixer can be provided simultaneously limits conversion loss to less than one decibel, maximizes total spurious free dynamic range, minimizes local oscillator power and radiation, and presents a broad band, purely resistive load termination to the prior analog stage. While one or more of the foregoing features may be provided by an image reject mixer in accordance with at least one embodiment, other embodiments need not offer such features and/or may offer other features not set forth above.

In accordance with at least one embodiment, a simple, low cost, and high dynamic range quadrature down conversion of signals to baseband for subsequent signal processing is provided. In accordance with at least one embodiment, commutating switches are used in combination with operational amplifier integrators to sample a signal of interest and convert the signal directly to baseband in-phase and quadrature signals. The in-phase and quadrature signals are then presented analog to digital converters or analog phasing networks for subsequent signal processing.

In the following drawings, like reference characters represent corresponding elements throughout the several views. Specific elements illustrated also represent a range of equivalents. For example, a fully differential operational amplifier represents a range of equivalents that includes, but is not limited to, two single ended operational amplifiers with their non-inverting inputs tied to ground potential. Thus, for example, a term such as differential operational amplifier should be understood to broadly represent a range of equivalents for providing the functionality of an operational amplifier in the context of differential signals.

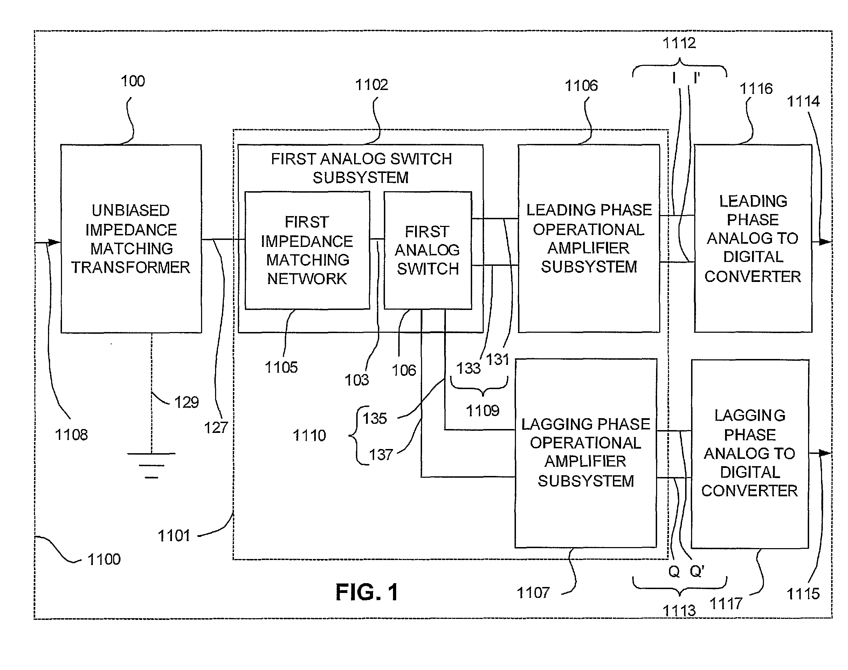

FIG. 1 is a block diagram illustrating an example of a direct conversion receiver in accordance with at least one embodiment. The direct conversion receiver 1100 comprises a phase sampling detector 1101. The phase sampling detector 1101 1 comprises first analog switch subsection 1102, leading phase operational amplifier subsection 1106, and lagging phase operational amplifier subsection 1107. First analog switch subsection 1102 comprises first impedance matching network 1105 and first analog switch 106.

The direct conversion receiver 1100 further comprises unbiased transformer 100, leading phase analog to digital converter 141, and lagging phase analog to digital converter 143. Unbiased transformer 100 receives input 1108 and magnetically couples input 1108 to first winding terminal 127 and second winding terminal 129, where first winding terminal 127 and second winding terminal 129 are of opposite polarity. Unbiased transformer 100 is coupled via first winding terminal 127 to an input first impedance matching resistor terminal of first impedance matching network 1105 (which may, for example, be implemented as an impedance matching resistor). An output first impedance matching resistor terminal of first impedance matching network 1105 is coupled to via coupling 103 to a first analog switch input terminal of first analog switch 106. An input sampling clock (e.g., a local oscillator (LO)) is coupled to first analog switch 106 to control commutation of switch elements within first analog switch 106 to selectively couple and isolate the first analog switch input terminal to and from couplings 131, 133, 135, and 137 during appropriate phases (e.g., quadrature phases) so as to provide samples of appropriate phase (e.g., in-phase (I) and quadrature (Q) samples) to leading phase operational amplifier subsystem 1106 and lagging phase operational amplifier subsystem 1107 via couplings 131, 133, 135, and 137. A first analog switch output terminal of first analog switch 106 is coupled to a first leading phase operational amplifier input of leading phase operational amplifier subsystem 1106. For example, a leading phase analog switch output terminal may be coupled via coupling 131 to the first leading phase operational amplifier input of leading phase operational amplifier subsystem 1106. As another example, an opposite leading phase analog switch output terminal (which may, for example, represent a phase sample 180 degrees advanced from that phase sample obtained via the leading phase analog switch output terminal) may be coupled via coupling 133 to an opposite first leading phase operational amplifier input of leading phase operational amplifier subsystem 1106.

Leading phase operational amplifier subsystem 1106 is coupled to leading phase analog to digital converter 141 via, for example, couplings 1112, which comprise an I output and an I' output. Analog to digital converter 141 is coupled to and provides an output 1114.

Unbiased transformer 100 is coupled via second winding terminal 129 to either a fixed potential, such as a ground potential, (e.g., for a single ended phase sampling detector) or an input second impedance matching resistor terminal of a second impedance matching resistor (e.g., for a differential phase sampling detector).

Lagging phase outputs (e.g., quadrature outputs) of first analog switch 106 are coupled to lagging phase operational amplifier subsystem 1107 via couplings 135 and 137. Lagging phase operational amplifier subsystem 1107 is coupled to analog to digital converter 143 via, for example, couplings 1113, which comprise a Q output and a Q' output. Analog to digital converter 143 is coupled to and provides an output 1115.

An input signal applied at input 1108 is magnetically coupled, yet isolated, across unbiased impedance matching transformer 100 to produce an output across first winding terminal 127 and second winding terminal 129. The output at first winding terminal 127 is applied to an input first impedance matching resistor terminal of a first impedance matching network 1105. First impedance matching network 1105 provides proper termination impedance for the unbiased impedance matching transformer 100, which transfers power efficiently and prevents unwanted reflections. An output first impedance matching resistor terminal of the first impedance matching network 1105 is coupled to and switched by first analog switch 106 to one or more of couplings 131, 133, 135, and 137. Couplings 1109, which comprise couplings 131 and 133, are coupled from analog switch 106 to leading phase operational amplifier subsystem 1106. Couplings 1110, which comprise couplings 135 and 137, are coupled from first analog switch 106 to lagging phase operational amplifier subsystem 1107. For example, coupling 131 can communicate a leading phase signal to a first leading phase operational amplifier input of leading phase operational amplifier subsystem 1106. Coupling 133 can communicate an opposite leading phase signal to a second leading phase operational amplifier input of leading phase operational amplifier subsystem 1106. Coupling 135 can communicate a lagging phase signal to a first lagging phase operational amplifier input of lagging phase operational amplifier subsystem 1107. Coupling 137 can communicate an opposite lagging phase signal to a second lagging phase operational amplifier input of lagging phase operational amplifier subsystem 1107.

Leading phase operational amplifier subsystem 1106 amplifies and maintains a leading phase sample obtained by the operation of first analog switch 1102. Lagging phase operational amplifier 1107 amplifies and maintains a lagging phase sample obtained by the operation of first analog switch 1102. Leading phase operational amplifier subsystem 1106 provides its leading phase sample to leading phase analog to digital converter 1116 via leading phase sample output 1112, which, for example may include complementary I and I' signals. Lagging phase operational amplifier subsystem 1107 provides its lagging phase sample to lagging phase analog to digital converter 1117 via lagging phase sample output 1113, which, for example, may include complementary Q and Q' signals. Leading phase analog to digital converter 1116 converts the leading phase sample to a leading phase sample digital representation, which it provides at output 1114 for digital signal processing. Lagging phase analog to digital converter 1117 converts the lagging phase sample to a lagging phase sample digital representation, which it provides at output 1115 for digital signal processing.

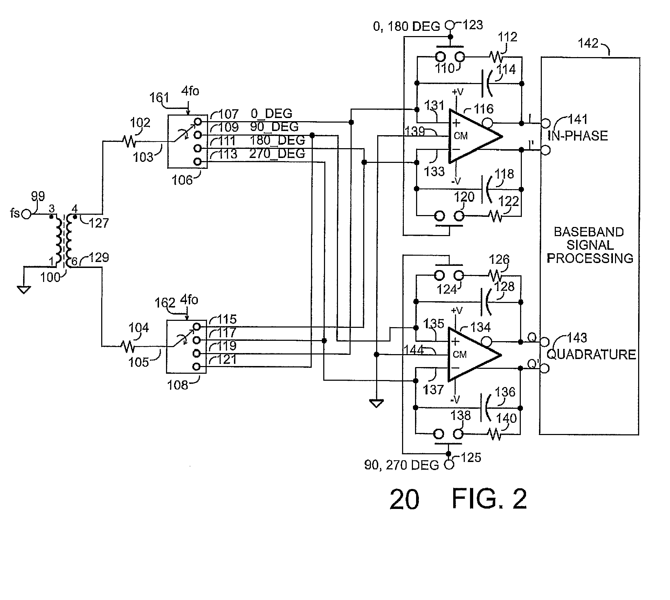

FIG. 2 is a schematic diagram illustrating an example of a double balanced direct conversion receiver with switched feedback loop in accordance with at least one embodiment. Direct conversion receiver 20 includes a transformer 100, resistors 102, 104, 112, 122, 126, and 140, first analog switch 106 and second analog switch 108, which may, for example, be implemented using 4:1 1 analog multiplexers, capacitors 114, 118, 128, and 136, resistors 112, 122, 126, and 140, fully differential operational amplifiers 116 and 134, analog switches 110, 120, 124, and 138, and baseband signal processing subsystem 142.

In operation, a RF or IF signal fₛ is received at input 99 of the transformer 100, which may comprise either a transformer or active components. The differential RF signals at first winding terminal 127 and second winding terminal 129 are connected in turn to first impedance matching resistor 102 and second impedance matching resistor 104 that resistively terminate the prior stage in its characteristic impedance. The signals pass through first impedance matching resistor 102 and second impedance matching resistor 104 to input 103 of a first analog switch 106 and input 105 of a second analog switch 108, respectively. First analog switch 106 and second analog switch 108 are illustrated as commutating switches that are switched among plural outputs in accordance with a phase of a first clock signal 161 and a second clock signal 162, respectively. Resistors 102 and 104 in conjunction with resistors 112, 122, 126, and 140 also determine the mixer's conversion gain. Commutating switch 106 switches input 103 to outputs 107, 109, 111, and 113 in response to a phase of first clock signal 161. Commutating switch 108 switches input 105 to outputs 115, 117, 119, and 121 in response to a phase of second clock signal 162. The rate at which commutating switches 106 and 108 switch is determined by the control signals present at first clock input 161 and second clock input 162, respectively. In accordance with at least one embodiment, the switching rate of the control signals at inputs 161 and 162 are substantially equal to four times the local oscillator frequency that would exist in a simple direct conversion receiver. Therefore, input 103 switches to outputs 107, 109, 111, and 113 and input 105 switches to outputs 115, 117, 119, and 121 substantially once during each period of input signal fₛ.

In accordance with at least one embodiment, commutating switches 106 and 108 remain at each of the four respective outputs for 25% of the period of the input signal. In accordance with at least one embodiment, commutating switches 106 and 108 remain closed at each of the respective outputs for substantially more or less than 25% of the period of the input signal.

In accordance with at least one embodiment, outputs 107 and 119 connect to input 131 and outputs 111 and 115 connect to input 133 of a fully differential operational amplifier 116. Further, outputs 109 and 121 connect to input 135 and outputs 113 and 117 connect to input 137 of a fully differential operational amplifier 134. The fully differential operational amplifiers 116 and 134 are powered from positive (+V) and negative (-V) power supplies so that their respective input terminals 131 and 133 and 135 and 137 operate at direct current "virtual" ground potential when common mode inputs 139 and 144 are connected to direct current ground potential.

A first leading phase resistor feedback switch 110 and a second leading phase resistor feedback switch 120 are switched by a control signal 123 synchronously with the 0 degree control phase and 180 degree control phase present at control signal inputs 161 and 162. A first lagging phase resistor feedback switch 124 and a second lagging phase resistor feedback switch 138 are switched by a control signal 125 synchronously with the 90 degree control phase and 270 degree control phase present at control signal inputs 161 and 162.

A common mode input 139 on the fully differential operational amplifier 116 and a common mode input 144 of the fully differential operational amplifier 134 are each connected directly to direct current ground potential. Grounding of the common mode inputs 139 and 144 causes each of the inputs 131, 133, 135, and 137 to operate at direct current "virtual" ground potential.

During the time commutating switches 106 and 108 connect to outputs 107 and 115 or 111 and 119, a charge will build up on capacitors 114 and 118 respectively. During the same time period, resistors 112 and 122 are connected by switches 110 and 120 across capacitors 114 and 118 respectively.

During the time commutating switches 106 and 108 connect to outputs 109 and 117 or 113 and 121, a charge will build up on capacitors 128 and 136. During the same time period, resistors 126 and 140 are connected by switches 124 and 138 across capacitors 128 and 136 respectively.

Fully differential amplifier 116 and capacitors 114 and 118 differentially integrate the input signal over 0 degree and 180 degree quadrants to form the in-phase output 141. Likewise, fully differential amplifier 134 and capacitors 128 and 136 differentially integrate the input signal during the 90 degree and 270 degree quadrants to form the quadrature output 143.

The in-phase output 141 and the quadrature output 143 are in turn fed to a baseband signal processing circuitry 142. The baseband signal processing circuitry 142 consists of either analog to digital conversion and digital signal processing hardware or discrete analog circuitry to perform the remaining signal selection, filtering, and demodulation functions.

In accordance with at least one embodiment, a phase sampling detector (which, as depicted, is a quadrature sampling detector) comprises the elements illustrated in FIG. 2 (with the exception of the baseband signal processing 142). This quadrature sampling detector is referred to herein as a "current mode quadrature sampling detector (CMQSD)." The name is derived from the detector output voltage being proportional to the current flowing into the "virtual" ground nodes through the input termination resistors and analog sampling switches. More generically, a CMQSD can be referred to as a "current mode phase sampling detector (CMPSD)," which need not be limited to a quadrature output with a 90-degree phase offset.

In accordance with at least one embodiment, a CMQSD can be implemented so as to provide performance that may exceed that of existing image reject mixer and quadrature sampling detectors in one or more respects. For example, a quadrature sampling detector and specifically the CMQSD offers a 6-7 dB decrease in conversion loss over existing image reject mixer technology. The conversion loss of a CMQSD can be less than 1 dB resulting in a lower noise figure and thus higher sensitivity.

Typical existing quadrature sampling detectors rely on a bias network to provide direct current bias to the analog sampling switches. Bias is typically required in such existing detectors to minimize on resistance modulation and resulting distortion due to incoming signal modulation of the gate to source voltage on the analog switches. However, in accordance with at least one embodiment, the CMQSD operates analog switches at direct current "virtual" ground potential thereby minimizing gate to source and on resistance modulation. This results in lower distortion for a given input signal level, hence higher dynamic range. Further, in accordance with at least one embodiment, the input signal is divided across both the input termination resistors and the analog sampling switch. In accordance with at least one embodiment, less than 5% of the input signal voltage will be present across the analog sampling switch resulting in further reduced distortion. In accordance with at least one embodiment, all analog switches operate within the operational amplifier feedback loop to further reduce overall distortion from the switch.

In accordance with at least one embodiment, another aspect where a CMQSD can offer improved performance is that the CMQSD input terminal presents a resistive termination to the prior RF or IF stage. This effect can be achieved, in accordance with at least one embodiment, by the analog sampling switches connecting the input termination resistors directly to virtual ground potential regardless of input signal and local oscillator frequencies. Existing quadrature sampling detectors typically require that a complex diplexer filter be installed on its output in order to properly terminate the input stage, which in turn increases noise figure by 3 dB.

In accordance with at least one embodiment, a CMQSD can enable a lower local oscillator drive amplitude, which results in improved noise figure and local oscillator radiation with increasing frequency. Local oscillator conducted radiation is further attenuated by input termination resistors 102 and 104. The result is that a CMQSD can be implemented, in accordance with at least one embodiment, to meet regulating body electromagnetic conducted radiation standards without a need for buffer amplifiers.

In accordance with at least one embodiment, a CMQSD can be implemented such that resistors 112, 118, 126, and 140 and capacitors 114, 118, 128, and 136 combine to form a tracking band pass filter centered at fₒ, the local oscillator frequency. The tracking filter bandwidth is simply adjusted by the correct selection of resistors 112, 118, 126, and 140 and capacitors 114, 118, 128, and 136. Bandwidth changes can be accomplished during operation by selecting resistor and capacitor values using analog switches or mechanical relays. In accordance with at least one embodiment, the CMQSD also provides conversion gain that is directly proportional to the division ratio of the value of the feedback resistors 112, 118, 126, and 140 to the value of the input termination resistors 102 and 104.

The fully balanced operation of at least one embodiment of the CMQSD functions to differentially subtract charge injection, reducing second order distortion and lowering local oscillator radiation.

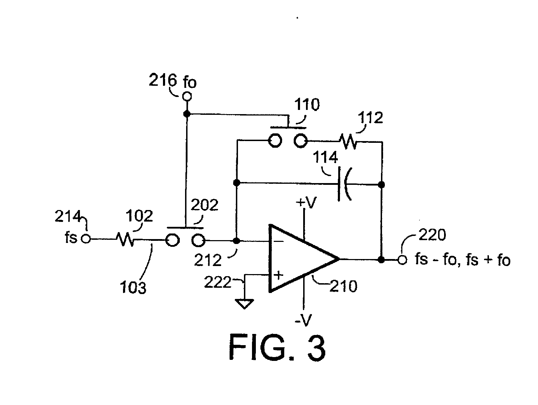

FIG. 3 is a schematic diagram illustrating an example of a direct conversion receiver in accordance with at least one embodiment. The direct conversion receiver comprises resistor 102, analog switch 202, resistor feedback analog switch 110, resistor 112, capacitor 114, and operational amplifier 210. An input signal fs is applied to signal input 214, which is coupled to the first terminal of resistor 102. A second terminal of resistor 102 is coupled to a first terminal of analog switch 202 at switch input 103. A second terminal of analog switch 202 is coupled to an inverting input 212 of operational amplifier 210, a first terminal of capacitor 114, and to a first terminal of resistor feedback analog switch 110. A sampling clock fo at sampling clock input 216 is coupled to a control terminal of analog switch 202 and to a control terminal of resistor feedback analog switch 110. A non-inverting input 222 of operational amplifier 210 is coupled to a ground potential. A second terminal of resistor feedback analog switch 110 is coupled to a first terminal of resistor 112 at node 218. An output of operational amplifier 210 is coupled to a second terminal of capacitor 114 and to a second terminal of resistor 112 at node 220, which also provides an output for the fs-fo output signal. A positive supply voltage is provided to positive supply input 224, and a negative supply voltage is provided to negative supply input 226.

A feedback loop exists between node 220 at the output of operational amplifier 210 and the inverting input 212 of operational amplifier 210. The feedback loop comprises a capacitive feedback loop and a resistive feedback loop. The capacitive feedback loop comprises capacitor 114 coupled between node 220 at the output of operational amplifier 210 and the inverting input 212 of operational amplifier 210. The resistive feedback loop comprises a series combination of resistor 112 in series with resistor feedback analog switch 110, wherein that series combination is coupled between node 220 at the output of operational amplifier 210 and the inverting input 212 of operational amplifier 210. In accordance with at least one embodiment, the capacitive feedback loop is coupled in parallel with the resistive feedback loop. By closing resistor feedback analog switch 110 and analog switch 202 through the application of sampling clock fo at sampling clock input 216, switch input 103 is coupled to the inverting input of operational amplifier 210, and the resistive feedback loop is closed, allowing operational amplifier 210 to operate in response to switch input 103, thereby providing a sampling period to sample a signal at switch input 103. By opening resistor feedback analog switch 110 and analog switch 202 through the application of sampling clock fo at sampling clock input 216, switch input 103 is isolated from the inverting input of operational amplifier 210, and the resistive feedback loop is opened, allowing capacitor 114 of the capacitive feedback loop to hold charge representative of the sample obtained from switch input 103 during the sampling period. Such a process of sampling switch input 103 based on the sampling clock allows frequency conversion of the input signal fs at signal input 214 as a function of the frequency of the sampling clock fo. Thus, under such conditions, the operational amplifier 210 provides a signal at node 220 comprising a first component having a first frequency equal to fs-fo and a second component having a second frequency equal to fs+fo. For example, if a modulated signal having a nominal carrier frequency of fs is applied at signal input 214 and a continuous wave (CW) sampling clock fo is applied at sampling clock input 216, where fs is equal to fo, the circuit provides an output at node 220 where the modulated signal is downconverted to a nominal carrier frequency of zero Hertz (typically referred to as direct current (DC)), which presents the modulated signal at baseband (i.e., as a demodulated signal).

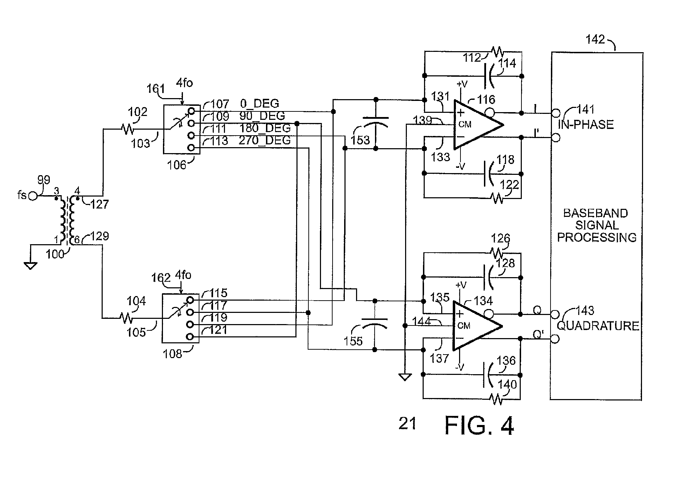

FIG. 4 is a schematic diagram illustrating an example of a double balanced direct conversion receiver in accordance with at least one embodiment. The double balanced direct conversion receiver 21 comprises an unbiased transformer 100, a first impedance matching resistor 102, a second impedance matching resistor 104, a first analog switch 106, a second analog switch 108, capacitors 153 and 155, fully differential operational amplifiers 116 and 134, capacitors 114, 118, 128, and 136, resistors 112, 122, 126, and 140, and baseband signal processing subsystem 142. The fully differential operational amplifiers may be implemented using either two of the individual operational amplifier circuits in shown in FIG. 3 driven differentially or alternately a monolithic fully differential amplifier. An input signal fs is applied at signal input 99 to a first primary winding terminal of unbiased transformer 100. A second primary winding terminal of unbiased transformer 100 is coupled to a ground potential. A first winding terminal 127 of a secondary winding of unbiased transformer 100 is coupled to a first terminal of first impedance matching resistor 102. A second winding terminal 129 of the secondary winding of unbiased transformer 100 is coupled to a first terminal of second impedance matching resistor 104. A second terminal of first impedance matching resistor 102 is coupled to an input 103 of first analog switch 106. A second terminal of second impedance matching resistor 104 is coupled to an input 105 of second analog switch 108. A commutation input 161 is coupled to first analog switch 106. A commutation input 162 is coupled to second analog switch 108. A commutation signal at commutation input 161 causes first analog switch 106 to switch input 103 among outputs 107, 109, 111, and 113 in sequence. A commutation signal at commutation input 162 causes second analog switch 108 to switch input 105 among outputs 115, 117, 119, and 121 in sequence.

Output 107 is coupled to output 119 and to a first terminal of capacitor 153, a first terminal of resistor 112, a first terminal of capacitor 114, and to a first differential input 131 of fully differential operational amplifier 116. Output 109 is coupled to output 121 and to a first terminal of capacitor 155, a first terminal of resistor 126, a first terminal of capacitor 128, and a first differential input 135 of fully differential operational amplifier 134. Output 111 is coupled to output 115 and to a second terminal of capacitor 153, a first terminal of capacitor 118, a first terminal of resistor 122, and to a second differential input 133 of fully differential operational amplifier 116. Output 113 is coupled to output 117 and to a second terminal of capacitor 155, a first terminal of capacitor 136, a first terminal of resistor 140, and a second differential input 137 of fully differential operational amplifier 134.

A second terminal of resistor 112 is coupled to a second terminal of capacitor 114 and to an in-phase output I of fully differential operational amplifier 116, which is coupled to an in-phase input of baseband signal processing subsystem 142. A second terminal of resistor 122 is coupled to a second terminal of capacitor 118 and to a complementary in-phase output I' of fully differential operational amplifier 116, which is coupled to a complementary in-phase input of baseband signal processing subsystem 142.

A second terminal of resistor 126 is coupled to a second terminal of capacitor 128 and to a quadrature output Q of fully differential operational amplifier 134, which is coupled to a quadrature input of baseband signal processing subsystem 142. A second terminal of resistor 140 is coupled to a second terminal of capacitor 136 and to a complementary quadrature output Q' of fully differential operational amplifier 134, which is coupled to a complementary quadrature input of baseband signal processing subsystem 142.

A common mode input 139 of fully differential operational amplifier 116 is coupled to ground potential. A common mode input 144 of fully differential operational amplifier 134 is coupled to ground potential. A positive supply voltage is provided to a positive supply input 145 of fully differential operational amplifier 116 and to a positive supply input 149 of fully differential operational amplifier 134. A negative supply voltage is provided to a negative supply input 147 of fully differential operational amplifier 116 and to a negative supply input 151 of fully differential operational amplifier 134.

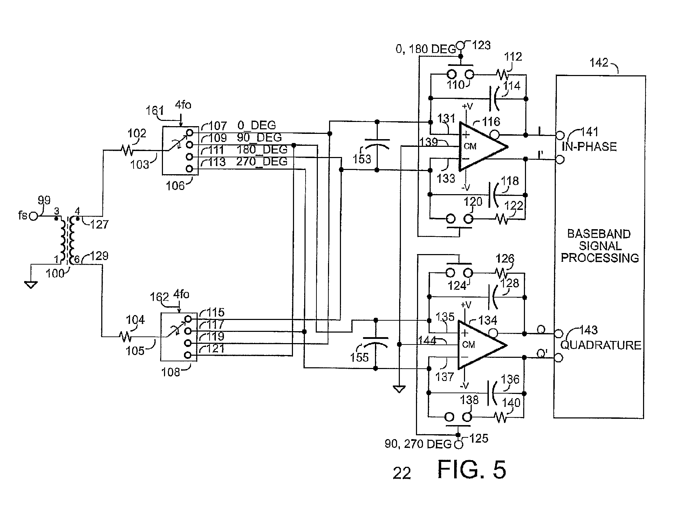

FIG. 5 is a schematic diagram illustrating an example of a double balanced direct conversion receiver with switched feedback loop in accordance with at least on embodiment. The double balanced direct conversion receiver 22 with switched feedback loop comprises differential capacitors 153 and 155, where differential capacitor 153 is coupled across first differential input 131 and second differential input 133 and differential capacitor 155 is coupled across first differential input 135 and second differential input 137. FIG. 5 is similar to FIG. 4 but has resistor feedback switches added. Outputs 107 and 119 are coupled to the first terminal of first leading phase resistor feedback switch 110. The second terminal of first leading phase resistor feedback switch 110 is coupled to the first terminal of resistor 112. Outputs 111 and 115 are coupled to a first terminal of second leading phase resistor feedback switch 120. The second terminal of second leading phase resistor feedback switch 120 is coupled to the first terminal of resistor 122. Outputs 109 and 121 are coupled to a first terminal of first lagging phase resistor feedback switch 124. The second terminal of first lagging phase resistor feedback switch 124 is coupled to the first terminal of resistor 126. Outputs 113 and 117 are coupled to the first terminal of second lagging phase resistor feedback switch 125. The second terminal of second lagging phase resistor feedback switch 125 is coupled to the first terminal of resistor 140.

A control input 123 is coupled to a control terminal of first leading phase resistor feedback switch 110 and to a control terminal of second leading phase resistor feedback switch 120. A control input 125 is coupled to a control terminal of first lagging phase resistor feedback switch 124 and to a control terminal of second lagging phase resistor feedback switch 138. In accordance with at least one embodiment, control input 123 is active for 0 and 180 degree phases and the control input 125 is active for 90 and 270 degree phases, wherein such phases are synchronized in relation to the in-phase commutation signal provided to commutation input 161 and the quadrature commutation signal provided to commutation input 162.

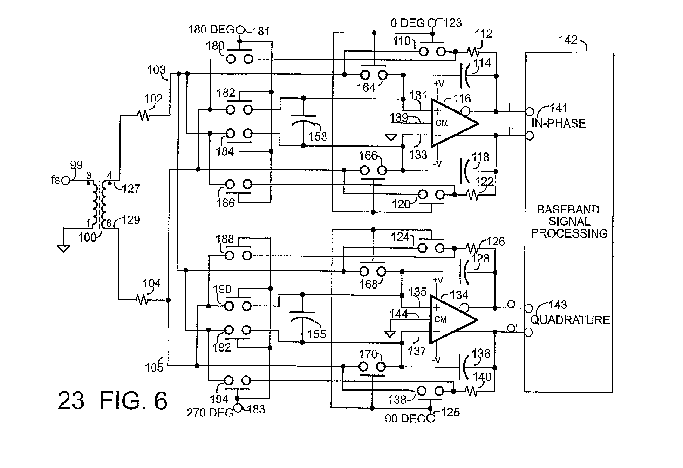

FIG. 6 is a schematic diagram illustrating an example of a double balanced direct conversion receiver with switched feedback loop in accordance with at least one embodiment. The double balanced direct conversion receiver 23 with switched feedback loop comprises differential capacitors 153 and 155, where differential capacitor 153 is coupled across first differential input 131 and second differential input 133 and differential capacitor 155 is coupled across first differential input 135 and second differential input 137. An input signal fs is applied at signal input 99, which is coupled to a first primary winding terminal of a primary winding of unbiased transformer 100. A second primary winding terminal of the primary winding of unbiased transformer is coupled to ground potential. A first winding terminal 127 of a secondary winding of unbiased transformer 100 is coupled to a first terminal of first impedance matching resistor 102. A second winding terminal 129 of the secondary winding of unbiased transformer 100 is coupled to a first terminal of second impedance matching resistor 104.

A second terminal of first impedance matching resistor 102 is coupled to a first terminal of first leading phase resistor feedback switch 110, to a first terminal of analog switch 164, to a first terminal of analog switch 184, to a first terminal of analog switch 186, to a first terminal of analog switch 168, to a first terminal of first lagging phase resistor feedback switch 124, to a first terminal of analog switch 192, and to a first terminal of analog switch 194. A second terminal of second impedance matching resistor 104 is coupled to a first terminal of analog switch 180, to a first terminal of analog switch 182, to a first terminal of analog switch 166, to a first terminal of second leading phase resistor feedback switch 120, to a first terminal of analog switch 188, to a first terminal of analog switch 190, to a first terminal of analog switch 170, and to a first terminal of second lagging phase resistor feedback switch 138.

The second terminal of analog switch 180 is coupled to the second terminal of first leading phase resistor feedback switch 110 and to the first terminal of resistor 112. The second terminal of analog switch 182 is coupled to a first terminal of capacitor 153, to a second terminal of analog switch 164, to a first differential input 131 of fully differential operational amplifier 116, and to a first input of capacitor 114. A second terminal of analog switch 184 is coupled to a second terminal of capacitor 153, to a second differential input 133 of fully differential operational amplifier 116, to a second terminal of analog switch 166, and to a first terminal of capacitor 118. A second terminal of analog switch 186 is coupled to a second terminal of second leading phase resistor feedback switch 120 and to a first terminal of resistor 122.

The second terminal of analog switch 188 is coupled to a second terminal of first lagging phase resistor feedback switch 124 and to a first terminal of resistor 126. The second terminal of analog switch 190 is coupled to a first terminal of capacitor 155, to a second terminal of analog switch 168, to a first terminal of capacitor 128, and to a first differential input 135 of fully differential operational amplifier 134. A second terminal of analog switch 192 is coupled to a second terminal of capacitor 155, to a second differential input 137 of fully differential operational amplifier 134, to a second terminal of analog switch 170, and to a first terminal of capacitor 136. A second terminal of analog switch 194 is coupled to a second terminal of second lagging phase resistor feedback switch 138 and to a first terminal of resistor 140.

An in-phase output I of fully differential operational amplifier 116 is coupled to a second terminal of resistor 112, to a second terminal of capacitor 114, and to an in-phase input of baseband signal processing subsection 142. A complementary in-phase output I' of fully differential operational amplifier 116 is coupled to a second terminal of resistor 122, to a second terminal of capacitor 118, and to a complementary in-phase input of baseband signal processing subsection 142.

A quadrature output Q of fully differential operational amplifier 134 is coupled to a second terminal of resistor 126, to a second terminal of capacitor 128, and to a quadrature input of baseband signal processing subsystem 142. A complementary quadrature output Q' of fully differential operational amplifier 134 is coupled to a second terminal of resistor 140, to a second terminal of resistor 136, and to a complementary quadrature input of baseband signal processing subsystem 142.

A 0 degree control signal provided at control signal input 123 is coupled to a control terminal of first leading phase resistor feedback switch 110, to a control terminal of analog switch 164, to a control terminal of analog switch 166, and to control terminal of second leading phase resistor feedback switch 120. A 90 degree control signal provided at control signal input 125 is coupled to a control terminal of second lagging phase resistor feedback switch 138, to a control terminal of analog switch 170, to a control terminal of analog switch 168, and to a control terminal of first lagging phase resistor feedback switch 124. A 180 degree control signal provided at control signal input 181 is coupled to a control terminal of analog switch 180, to a control terminal of analog switch 182, to a control terminal of analog switch 184, to a control terminal of analog switch 186. A 270 degree control signal provided at control signal input 183 is coupled to a control terminal of analog switch 188, to a control terminal of analog switch 190, to a control terminal of analog switch 192, and to a control terminal of analog switch 194.

As described above with reference to FIG. 3, the circuit of FIG. 6 comprises feedback loops for its operational amplifiers, and those feedback loops comprise resistive and capacitive feedback loops. As an example, a capacitive feedback loop comprises capacitor 114, which is coupled between in-phase output I of fully differential operational amplifier 116 and first differential input 131 of fully differential operational amplifier 116, and a resistive feedback loop comprises a series combination of resistor 112 in series with first leading phase resistor feedback switch 110 in series with analog switch 164, wherein that series combination is coupled between in-phase output I of fully differential operational amplifier 116 and first differential input 131 of fully differential operational amplifier 116. As compared with the embodiment illustrated in FIG. 3, where analog switch 202, which can function as a commutation switch, selectively coupling and isolating an operational amplifier input to and from a signal input, was not within the resistive feedback loop, in accordance with at least one embodiment, as illustrated in FIG. 6, analog switch 164, which can function as a commutation switch, selectively coupling and isolating an operational amplifier input to and from a signal input, is within the resistive feedback loop. By including such an analog switch in the resistive feedback loop, the operational amplifier can compensate for non-ideal phenomena, such a nonlinearity, introduced by the analog switch, thereby improving performance of the circuit. For example, inclusion of the analog switch, such as an analog switch used as a commutation switch, in the resistive feedback loop, substantially lower conversion loss can be achieved.

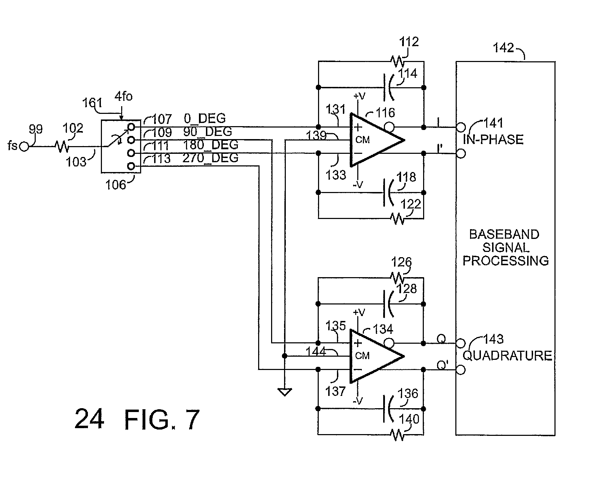

FIG. 7 is a schematic diagram illustrating an example of a single balanced direct conversion receiver in accordance with at least one embodiment. The single balanced direct conversion receiver 24 is depicted as being implemented without differential capacitors but may alternatively be implemented with differential capacitors. An input signal fs is applied to a first terminal of resistor 102. The second terminal of resistor 102 is coupled to an input of first analog switch 106. A four-times clock frequency input is provided to first analog switch 106 to commutate first analog switch 106. A 0 degree phase output of first analog switch 106 is coupled to a first terminal of resistor 112, a first terminal of capacitor 114, and a first differential input of fully differential operational amplifier 116. A 90 degree phase output of first analog switch 106 is coupled to a first terminal of resistor 126, a first terminal of capacitor 128, and a first differential input of fully differential operational amplifier 134. A 180 degree phase output of first analog switch 106 is coupled to a second differential input of fully differential operational amplifier 116, to a first terminal of capacitor 118, and to a first terminal of resistor 122. A 270 degree phase output of first analog switch 106 is coupled to a second differential input of fully differential operational amplifier 134, to a first terminal of capacitor 136, and to a first terminal of resistor 140. A common mode input 139 of fully differential operational amplifier 116 and a common mode input 144 of fully differential operational amplifier 134 are both coupled to ground potential.

A second terminal of resistor 112 is coupled to a second terminal of capacitor 114, to an in-phase output of fully differential operational amplifier 116, and to an in-phase input of baseband signal processing subsystem 142. A second terminal of resistor 122 is coupled to a second terminal of capacitor 118, to a complementary in-phase output of fully differential operational amplifier 116, and to a complementary in-phase input of baseband signal processing subsystem 142. A second terminal of resistor 126 is coupled to a second terminal of capacitor 128, to a quadrature output of fully differential operational amplifier 134, and to a quadrature input of baseband signal processing subsystem 142. A second terminal of resistor 140 is coupled to a second terminal of capacitor 136, to a complementary quadrature output of fully differential operational amplifier 134, and to a complementary quadrature input of baseband signal processing subsystem 142.

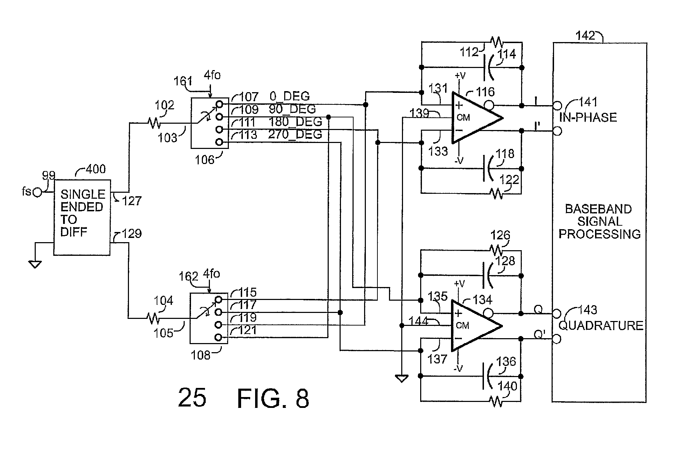

FIG. 8 is a schematic diagram illustrating an example of a double balanced direct conversion receiver in accordance with at least one embodiment. The double balanced direct conversion receiver 25 of FIG. 8 is similar to the double balanced direct conversion receiver 21 of FIG. 4 but with differential capacitors 153 and 155 omitted.

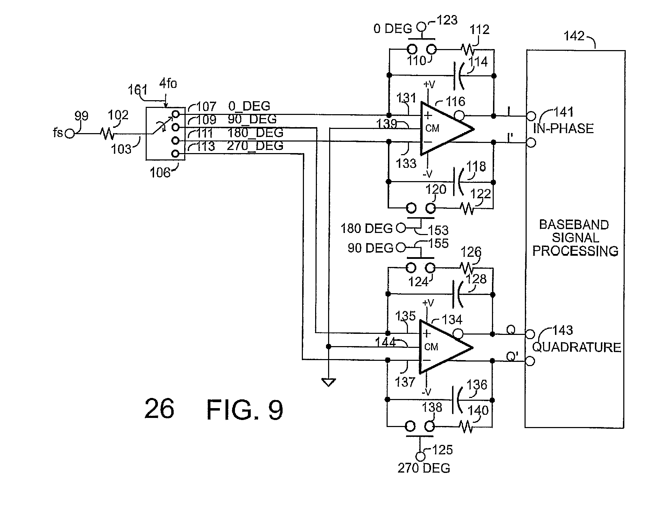

FIG. 9 is a schematic diagram illustrating an example of a single balanced direct conversion receiver with switched feedback loop in accordance with at least one embodiment. The single balanced direct conversion receiver 26 of FIG. 9 is similar to the single balanced direct conversion receiver 24 of FIG. 7 except that resistor feedback analog switches have been added.

The 0 degree phase output of first analog switch 106 is coupled to a first terminal of first leading phase resistor feedback switch 110. The second terminal of first leading phase resistor feedback switch 110 is coupled to the first terminal of resistor 112. The 90 degree phase output of first analog switch 106 is coupled to a first terminal of first lagging phase resistor feedback switch 124. The second terminal of first lagging phase resistor feedback switch 124 is coupled to the first terminal of resistor 126. The 180 degree phase output of first analog switch 106 is coupled to a first terminal of second leading phase resistor feedback switch 120. The second terminal of second leading phase resistor feedback switch 120 is coupled to the first terminal of resistor 122. A 270 degree phase output of first analog switch 106 is coupled to a first terminal of second lagging phase resistor feedback switch 138. The second terminal of second lagging phase resistor feedback switch 138 is coupled to the first terminal of resistor 140.

A control input 123 is coupled to a control terminal of first leading phase resistor feedback switch 110 and to a control terminal of second leading phase resistor feedback switch 120. A control input 125 is coupled to a control terminal of first lagging phase resistor feedback switch 124 and to a control terminal of second lagging phase resistor feedback switch 138. In accordance with at least one embodiment, control input 123 is active for 0 and 180 degree phases and the control input 125 is active for 90 and 270 degree phases, wherein such phases are synchronized in relation to the in-phase commutation signal provided to commutation input 4fo.

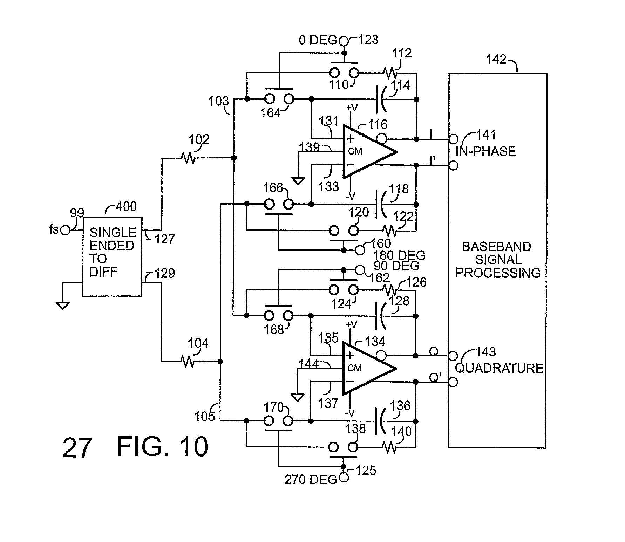

FIG. 10 is a schematic diagram illustrating an example of a single balanced direct conversion receiver with switched feedback loop in accordance with at least one embodiment. The single balanced direct conversion receiver 27 with switched feedback loop is depicted as being implemented without differential capacitors but may alternatively be implemented with differential capacitors. An input signal fs is applied to a signal input 99 of single ended to differential converter 400. As an example, single ended to differential converter 400 may be implemented using a transformer, such as unbiased transformer 100, or other circuitry, such as an amplifier, for example, a high speed fully differential operational amplifier. Similarly, other examples of transformers described herein may be implemented using either an electromagnetic transformer, such as an unbiased electromagnetic transformer, or other circuitry, such as an amplifier, for example, an operational amplifier, such as a high speed differential operational amplifier. Moreover, a suitable single ended to differential converter may be implemented in an integrated circuit or using discrete components. A ground potential reference of single ended to differential converter 400 is coupled to a ground potential. A first differential output 127 of single ended to differential converter 400 is coupled to a first terminal of resistor 102. A second differential output 129 of single ended to differential converter 400 is coupled to a first terminal of resistor 104. A second terminal of resistor 102 at node 103 is coupled to a first terminal of first leading phase resistor feedback switch 110, to a first terminal of analog switch 164, to a first terminal of analog switch 168, and to a first terminal of first lagging phase resistor feedback switch 124. A second terminal of resistor 104 at node 105 is coupled to a first terminal of analog switch 166, to a first terminal of second leading phase resistor feedback switch 120, to a first terminal of analog switch 170, and to a first terminal of second lagging phase resistor feedback switch 138.

A second terminal of first leading phase resistor feedback switch 110 is coupled to a first terminal of resistor 112. A second terminal of second leading phase resistor feedback switch 120 is coupled to a first terminal of resistor 122. A second terminal of analog switch 164 is coupled to a first terminal of capacitor 114 and to a first differential input 131 of fully differential operational amplifier 116. A second terminal of analog switch 166 is coupled to a second differential input 133 of fully differential operational amplifier 116 and to a first terminal of capacitor 118. A common mode input 139 of fully differential operational amplifier 116 is coupled to ground potential.

A second terminal of resistor 112 is coupled to a second terminal of capacitor 114, to an in-phase output of fully differential operational amplifier 116, and to an in-phase component I of in-phase output 141. A second terminal of resistor 122 is coupled to a second terminal of capacitor 118, to a complementary in-phase output of fully differential operational amplifier 116, and to a complementary in-phase component I' of in-phase output 141. The in-phase output 141 may be provided to baseband signal processing block 142, where it may, for example, be provided to an in-phase analog-to-digital converter to obtain a digital representation of the in-phase signal present at in-phase output 141.

A second terminal of first lagging phase resistor feedback switch 124 is coupled to a first terminal of resistor 126. A second terminal of second lagging phase resistor feedback switch 138 is coupled to a first terminal of resistor 140. A second terminal of analog switch 168 is coupled to a first terminal of capacitor 128 and to a first differential input 135 of fully differential operational amplifier 134. A second terminal of analog switch 170 is coupled to a second differential input 137 of fully differential operational amplifier 134 and to a first terminal of capacitor 136. A common mode input 144 of fully differential operational amplifier 134 is coupled to ground potential. As with any fully differential operational amplifier, it should be understood that a fully differential operational amplifier may alternatively be implemented as a pair of ordinary, non-differential operational amplifiers. For example, the inverting inputs of the pair of ordinary, non-differential operational amplifiers may be used as differential inputs and the non-inverting inputs of the pair of ordinary, non-differential operational amplifiers may be used as the common mode input and tied to ground.

A second terminal of resistor 126 is coupled to a second terminal of capacitor 128, to an in-phase output of fully differential operational amplifier 134, and to a quadrature component Q of quadrature output 143. A second terminal of resistor 140 is coupled to a second terminal of capacitor 136, to a complementary in-phase output Q' of fully differential operational amplifier 134, and to a complementary in-phase component of quadrature output 143. The quadrature output 143 may be provided to baseband signal processing block 142, where it may, for example, be provided to a quadrature analog-to-digital converter to obtain a digital representation of the quadrature signal present at in-phase output 141. As a general case, where what are referred to as the in-phase signal and the quadrature signal may be, but need not be, temporally separated from one another by a phase angle of 90 degrees (i.e., they may be temporally separated from one another by a phase angle of more or less than 90 degrees), the terms in-phase and quadrature may be generalized as leading phase and lagging phase, respectively, or as lagging phase and leading phase, respectively.

A 0 degree control input 123 is coupled to a control input of first leading phase resistor feedback switch 110 and to a control input of analog switch 164. A 180 degree control input 160 is coupled to a control input of analog switch 166 and to a control input of second leading phase resistor feedback switch 120. A 90 degree control input 162 is coupled to a control input of first lagging phase resistor feedback switch 124 and to a control input of analog switch 168. A 270 degree control input 125 is coupled to a control input of analog switch 170 and to a control input of second lagging phase resistor feedback switch 138.

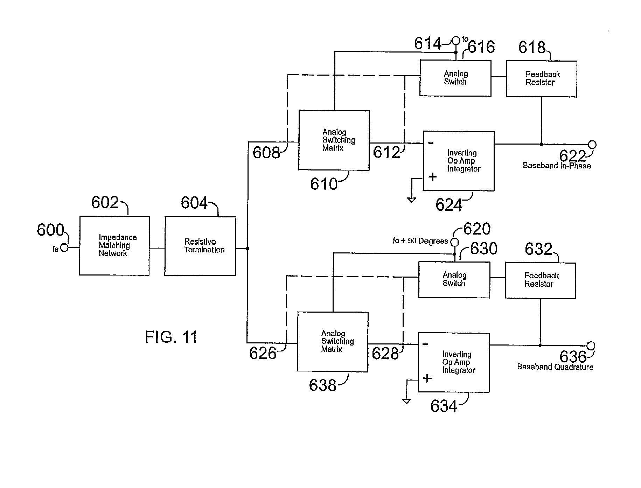

FIG. 11 is a block diagram illustrating an example of a phase sampling detector in accordance with at least one embodiment. An input signal fs is applied at signal input 600 which is coupled to impedance matching network 602. An output of impedance matching network 602 is coupled to an input of resistive termination 604. An output of resistive termination 604 is coupled to an input of analog switching matrix 610 at node 608 and to an input of analog switching matrix 638 at node 626. An output of analog switching matrix 610 is coupled to an inverting input of inverting operational amplifier/integrator 624 at node 612. An output of analog switching matrix 638 is coupled to an inverting input of inverting operational amplifier/integrator 634 at node 628. A non-inverting input of inverting operational amplifier/integrator 624 is coupled to a ground potential. A non-inverting input of inverting operational amplifier/integrator 634 is coupled to a ground potential.

A first input of analog switch 616 is coupled either to node 608 or to node 612. A first input of analog switch 630 is coupled either to node 626 or to node 628. A control signal fo is applied to control input 614, which is coupled to a control input of analog switching matrix 610 and to a control input of analog switch 616. A control signal fo+90 degrees is applied to control input 620, which is coupled to a control input of analog switching matrix 638 and to a control input of analog switch 630. A second terminal of analog switch 616 is coupled to a first terminal of feedback resistor 618. A second terminal of analog switch 630 is coupled to a first terminal of feedback resistor 632. A second terminal of feedback resistor 618 is coupled to an output of inverting operational amplifier/integrator 624 and to a baseband in-phase output 622. A second terminal of feedback resistor 632 is coupled to an output of inverting operational amplifier 634 and to a baseband quadrature output 636.

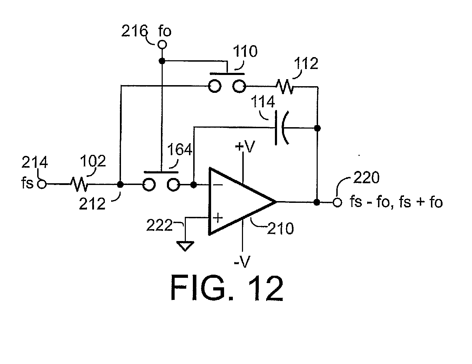

FIG. 12 is a schematic diagram illustrating an example of a direct conversion receiver in accordance with at least one embodiment. The direct conversion receiver comprises resistor 102, analog switch 164, resistor feedback analog switch 110, resistor 112, capacitor 114, and operational amplifier 210. An input signal fs is applied to signal input 214, which is coupled to the first terminal of resistor 102. A second terminal of resistor 102 is coupled to a first terminal of analog switch 164 at switch input 212 and to a first terminal of resistor feedback analog switch 110. A second terminal of analog switch 164 is coupled to an inverting input of operational amplifier 210 and to a first terminal of capacitor 114. A sampling clock fo at sampling clock input 216 is coupled to a control terminal of analog switch 164 and to a control terminal of resistor feedback analog switch 110. A non-inverting input 222 of operational amplifier 210 is coupled to a ground potential. A second terminal of resistor feedback analog switch 110 is coupled to a first terminal of resistor 112. An output of operational amplifier 210 is coupled to a second terminal of capacitor 114 and to a second terminal of resistor 112 at node 220, which also provides an output for the fs-fo, fs+fo output signal. A positive supply voltage is provided to a positive supply input of operational amplifier 210, and a negative supply voltage is provided to a negative supply input of operational amplifier 210.

A feedback loop exists between node 220 at the output of operational amplifier 210 and the inverting input of operational amplifier 210. The feedback loop comprises a capacitive feedback loop and a resistive feedback loop. The capacitive feedback loop comprises capacitor 114 coupled between node 220 at the output of operational amplifier 210 and the inverting input of operational amplifier 210. The resistive feedback loop comprises a series combination of resistor 112 in series with resistor feedback analog switch 110 in series with analog switch 164, wherein that series combination is coupled between node 220 at the output of operational amplifier 210 and the inverting input of operational amplifier 210. In accordance with at least one embodiment, the capacitive feedback loop is coupled in parallel with the resistive feedback loop. By closing resistor feedback analog switch 110 and analog switch 164 through the application of sampling clock fo at sampling clock input 216, switch input 212 is coupled to the inverting input of operational amplifier 210, and the resistive feedback loop is closed, allowing operational amplifier 210 to operate in response to switch input 212, thereby providing a sampling period to sample a signal at switch input 212. By opening resistor feedback analog switch 110 and analog switch 164 through the application of sampling clock fo at sampling clock input 216, switch input 212 is isolated from the inverting input of operational amplifier 210, and the resistive feedback loop is opened, allowing capacitor 114 of the capacitive feedback loop to hold charge representative of the sample obtained from switch input 212 during the sampling period. Such a process of sampling switch input 212 based on the sampling clock allows frequency conversion of the input signal fs at signal input 214 as a function of the frequency of the sampling clock fo. Thus, under such conditions, the operational amplifier 210 provides a signal at node 220 comprising a first component having a first frequency equal to fs-fo and a second component having a second frequency equal to fs+fo. For example, if a modulated signal having a nominal carrier frequency of fs is applied at signal input 214 and a continuous wave (CW) sampling clock fo is applied at sampling clock input 216, where fs is equal to fo, the circuit provides an output at node 220 where the modulated signal is downconverted to a nominal carrier frequency of zero Hertz (typically referred to as direct current (DC)), which presents the modulated signal at baseband (i.e., as a demodulated signal).

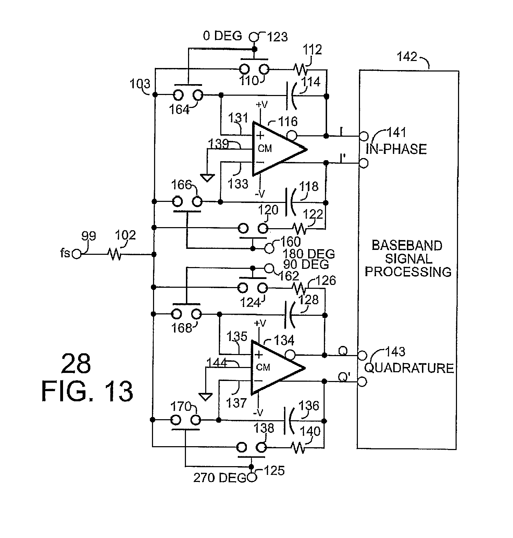

FIG. 13 is a schematic diagram illustrating an example of a direct conversion receiver in accordance with at least one embodiment. Direct conversion receiver 28 of FIG. 13 is similar to the single balanced direct conversion receiver 26 of FIG. 9 except that the first analog switch 106 is implemented by individual analog switches 164, 166, 168, and 170 that have been brought inside their respective resistive feedback loops in a manner similar to the single balanced direct conversion receiver 27 with switched feedback loop of FIG. 10 (but without the single ended to differential converter 400 of the single balanced direct conversion receiver 27 with switched feedback loop of FIG. 10). Unlike the single balanced direct conversion receiver 27 with switched feedback loop of FIG. 10, a RF or IF signal fₛ is received at input 99, which is coupled to first impedance matching resistor 102 that resistively terminates the prior stage in its characteristic impedance. The signals pass through first impedance matching resistor 102 and are applied to the switch inputs of analog switches 164, 166, 168, and 170, as well as to resistor feedback switches 110, 120, 124, and 138. Operation of analog switch 164 and resistor feedback switch 110 during a 0 degree portion of the CMQSD switching cycle obtains an in-phase (I) sample. Operation of analog switch 166 and resistor feedback switch 120 during a 180 degree portion of the CMQSD switching cycle obtains a complementary in-phase (I') sample. Operation of analog switch 168 and resistor feedback switch 124 during a 90 degree portion of the CMQSD switching cycle obtains a quadrature (Q) sample. Operation of analog switch 170 and resistor feedback switch 138 during a 270 degree portion of the CMQSD switching cycle obtains a complementary quadrature (Q') sample. The in-phase (I) and complementary in-phase (I') samples are provided at in-phase output 141 for use by baseband signal processing block 142. The quadrature (Q) and complementary quadrature (Q') samples are provided at quadrature output 143 for use by baseband signal processing block 142.

In accordance with at least one embodiment, during the 0 degree portion of the CMQSD switching cycle, outputs 107 and 115 are connected respectively to inputs 131 and 133 of fully differential amplifier 116. During this portion of the cycle, capacitor 114 will charge to the value of a first point and capacitor 118 will charge to the inverted value of the first point. During the 90 degree portion of the switching cycle, outputs 109 and 117 are connected respectively to inputs 135 and 137 of fully differential amplifier 134. During this portion of the cycle, capacitor 128 will charge to the value of a second point and capacitor 136 will charge to the inverted value of the second point.

During the second half of the signal cycle, the input polarities to fully differential amplifiers 116 and 134 are reversed from that of the first half cycle. During the 180 degree portion of the switching cycle, outputs 111 and 119 are connected respectively to inputs 133 and 131 of fully differential amplifier 116. During this portion of the cycle, capacitor 114 will charge to the inverted value of a third point and capacitor 118 will charge to the value of the third point. During the 270 degree portion of the switching cycle, outputs 113 and 121 are connected respectively to inputs 137 and 135 of fully differential amplifier 134. During this portion of the cycle, capacitor 128 will charge to the inverted value of a fourth point and capacitor 136 will charge to the value of the fourth point.

In the case that fₛ is a pure carrier with no information superimposed and is exactly equal in frequency to the local oscillator frequency fₒ, the output at baseband will be zero. Four evenly spaced samples of fₛ will be continuously taken at exactly the same points along the waveform representing a stationary output with no signal of interest at baseband. Any phase difference between is and fₒ will be represented by a direct current offset in the outputs 141 and 143.

The prior operation was described in the case where fₒ is exactly equal to fₛ. Next, consider the condition where oscillator frequency fₒ differs in frequency from fₛ by an amount equal to Δf, where Δf = fₛ - fₒ. In this case, the first, second, third, and fourth measurement points will no longer be stationary with respect to the contour of fₛ, as the frequency of the input signal, fₛ, is no longer equal to exactly four times fₒ. Since the first, second, third, and fourth points represent the integrated value of capacitors 114, 118, 128, and 136, the baseband output will change at a rate equal to Δf. When information is superimposed on fₛ, the CMQSD will translate those signals to baseband in the exactly the same manner as Δf is translated to baseband.

Switches 110, 120, 124, and 138 were ignored in the operational discussion of the embodiment above because the CMQSD translates signals to baseband in the same manner with or without those switches in operation. Without switches 110, 120, 124, and 138, the CMQSD has a conversion loss of substantially 6 dB. When utilized, switches 110, 120, 124, and 138 reduce conversion loss to substantially 1 dB.

Operation of the switches 110, 120, 124, and 138 are understood as follows. Switches 110 and 120 are activated during the 0 degree and 180 degree portions of the switching cycle thereby enabling feedback resistors 112 and 122 respectively. Resistors 112 and 122 in conjunction with resistors 102 and 104 set the baseband gain of fully differential amplifier 116 less the conversion loss due to the integration process.

During the 90 degree and 270 degree portions of the switching cycle, switches 110 and 120 are deactivated thus disconnecting feedback resistors 112 and 122. This operation causes output 141 to track the envelope of signal fₛ during the 0 degree and 180 degree portions of the switching cycle. During the 90 degree and 270 degree portions of the switching cycle, output 141 will be held at the integrated value of fₛ at the end of the prior 0 degree and 180 degree sampling periods respectively.

Switches 124 and 138, resistors 126 and 140, capacitors 128 and 136 and fully differential amplifier 134 function in the same manner as described above except for the switching phases. In this case, switches 124 and 138 are activated during the 90 degree and 270 degree and deactivated during the 0 degree and 180 degree and portions of the cycle to produce the integrated baseband signal at output 143.

### EXPERIMENTAL RESULTS

Multiple direct conversion receiver prototypes which utilize the CMQSD have been simulated and constructed to test various embodiments and components of the design. An example of one embodiment of the receiver design as shown in FIG. 4 was built using a dual 4:1 multiplexer/demultiplexer bus switch, two fully differential operational amplifiers and a dual D type Flip Flop configured as a Johnson Counter. Measurements were performed to determine two-tone, third order dynamic range (IMD DR3) within a 500 Hz detection bandwidth and 2 kHz tone spacing. At 14 MHz and 50 MHz, it was possible to achieve two tone, third order intermodulation dynamic range in excess 115 dB (measured at 2 kHz tone spacing in a 500 Hz bandwidth), an improvement of at least 10dB over the existing image reject mixers. Local oscillator radiation was confirmed to meet electromagnetic emissions standards across the tuning range permitted by the selected multiplexer/demultiplexer bus switch. It was also demonstrated that by placing the commutating switch at ground potential, it was possible to reduce local oscillator power by up to 60 percent versus specified commercial component drive levels. This directly correlated to greater than 6 dB reduction in local oscillator radiation. Further reduction is possible using low gate to source threshold FETs. Testing was also performed where bias was added to the switch inputs to raise their outputs above ground potential. While the circuit continues to work, dynamic range performance degrades as bias is increased above ground potential. The voltage standing wave ratio (VSWR) at the input to the CMQSD was measured to be less than 1.2:1 over the entire range from DC to 150 MHz regardless of local oscillator frequency.

The tested example of the embodiment of FIG. 4 exhibited substantially a 6 dB conversion loss as compared to substantially 1 dB in at least one embodiment that includes switching of the feedback resistors in operational amplifier feedback loop. The tested example of the embodiment shown in FIG. 6 was built using two quad 2:1 multiplexer/demultiplexers, two fully differential operational amplifiers, a dual D type Flip Flop configured as a Johnson Counter and a quad AND gate configured to provide four phase clocking. This tested example measured substantially 1 dB conversion loss with the operational amplifier configured for unity gain. An example of the embodiment of FIG. 5 combines feedback resistor switching with the simple input switching network of FIG. 4 to achieve substantially 1 dB of conversion loss.

At least one embodiment of the CMQSD is suitable to be incorporated into custom integrated circuits for enhanced performance over that achievable with discrete components. The CMQSD can be configured using various switching and input impedance matching topologies including for example single ended, differential, and bridge. Switches can incorporate for example commercially available multiplexer/demultiplexers, discrete transistors or FET switches or an array of transistor or FET switches. Various switching duty cycle and phasing can be used to optimize operation for specific applications and frequency range of operation.

Laboratory results show that at least one embodiment of the CMQSD will produce substantially higher spurious free dynamic range and lower electromagnetic emissions at significantly higher operating frequencies than existing image reject mixers. When constructed with high speed switches, CMQSD technology can now be extended into the multi-GHz frequency range.

In view of the degradation of dynamic range performance as DC bias is applied to the switch inputs of a commutating input switch (e.g., an analog switch) of a phase sampling detector implemented in accordance with at least one embodiment and the DC bias raises the voltage at the switch inputs away from ground potential, at least one embodiment continually maintains a first analog switch output terminal at ground potential. The ground potential is defined as the ground reference voltage of the input sampling clock (e.g., local oscillator (LO)) that controls commutation of the commutating input switches (e.g., analog switches). For example, with respect to FIG. 3, the ground potential is the ground reference voltage to which the sampling clock fo applied at sampling clock input 216 is referenced. In accordance with at least one embodiment, a first analog switch output terminal is continually maintained at no more than five percent of the maximum peak (i.e., peak, not peak-to-peak) input signal applied to the first analog switch input terminal. In accordance with at least one embodiment, a first analog switch output terminal is continually maintained at no more than ten percent of the maximum peak (i.e., peak, not peak-to-peak) input signal applied to the first analog switch input terminal. In accordance with at least one embodiment, a first analog switch output terminal is continually maintained at no more than twenty percent of the maximum peak (i.e., peak, not peak-to-peak) input signal applied to the first analog switch input terminal. In accordance with at least one embodiment, a first analog switch output terminal is continually maintained at no more than thirty percent of the maximum peak (i.e., peak, not peak-to-peak) input signal applied to the first analog switch input terminal. In accordance with at least one embodiment, a first analog switch output terminal is continually maintained at no more than forty percent of the maximum peak (i.e., peak, not peak-to-peak) input signal applied to the first analog switch input terminal. In accordance with at least one embodiment, a first analog switch output terminal is continually maintained at no more than fifty percent of the maximum peak (i.e., peak, not peak-to-peak) input signal applied to the first analog switch input terminal. In accordance with at least one embodiment, a first analog switch output terminal is continually maintained at no more than sixty percent of the maximum peak (i.e., peak, not peak-to-peak) input signal applied to the first analog switch input terminal. In accordance with at least one embodiment, a first analog switch output terminal is continually maintained at no more than eighty percent of the maximum peak (i.e., peak, not peak-to-peak) input signal applied to the first analog switch input terminal. In accordance with at least one embodiment, a first analog switch output terminal is continually maintained at no more than the maximum peak (i.e., peak, not peak-to-peak) input signal applied to the first analog switch input terminal.

In at least one embodiment, if any DC bias is applied, the DC bias applied to the input switch (including any bias that might be applied to either the switch input or the switch output) is always less than the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than eighty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than sixty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than fifty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than forty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than thirty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than twenty percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than ten percent of the maximum peak (i.e., peak, not peak-to-peak) input signal applied to the switch input. In at least one embodiment, if any DC bias is applied, the DC bias applied to the input switch (including any bias that might be applied to either the switch input or the switch output) is always less than five percent of the maximum peak (i.e., peak, not peak-to-peak) input signal applied to the switch input.

In accordance with at least one embodiment, the CMQSD offers the ability to reduce component count and cost, increase dynamic range, reduce electromagnetic radiation, and reduce power consumption. At least one embodiment may be beneficially applied to any or all of a variety of electronic apparatus and systems that involve the processing of signals, such as the conversion of signals in frequency. Example of electronic apparatus and systems for which use of at least one embodiment may be beneficial include, but are not limited to, amateur radio equipment, public safety radio equipment, business/industrial radio equipment, personal radio equipment, maritime radio equipment, aviation radio equipment, railroad radio equipment, government communication systems, military communication systems, weather/all-hazards radio equipment, wireless telephone equipment (including, but not limited to, wireless telephone subscriber equipment and wireless telephone infrastructure equipment), navigation equipment (e.g., satellite navigation equipment, including, but not limited to, receivers for satellite navigation signals and receivers for satellite-based or terrestrially based differential supplementation signals), scanning receivers, wireless data communications devices, data modems (including, but not limited to, DSL/cable modems), signals intelligence systems, broadcast radio receivers, broadcast television receivers, cable television receivers, spectrum surveillance systems, radio frequency (RF) test equipment, automated test equipment (ATE), short-range wireless interfaces for electronic devices and their accessories, apparatus and systems based on unlicensed intentional radiators of RF signals, etc. The proliferation of wireless devices and systems, as well as high-bandwidth wired and optical-fiber-based devices and systems, which typically require signal processing capability that may be beneficially implemented in accordance with at least one embodiment disclosed herein, underscores the utility and industrial utility of such at least one embodiment.

In accordance with at least one embodiment, apparatus comprises a phase sampling detector. In accordance with at least one embodiment, the phase sampling detector, which may, for example, be a quadrature sampling detector, comprises a leading phase operational amplifier subsystem; a first analog switch having a first analog switch output terminal coupled to a first leading phase operational amplifier input of the leading phase operational amplifier subsystem, the first analog switch output terminal being maintained continually at a ground potential; a lagging phase operational amplifier subsystem; and a second analog switch having a second analog switch output terminal coupled to a first lagging phase operational amplifier input of the lagging phase operational amplifier subsystem. The second analog switch output terminal is maintained continually at the ground potential. The leading phase operational amplifier subsystem is adapted to obtain a leading phase sample. The lagging phase operational amplifier subsystem is adapted to obtain a lagging phase sample. A nonzero phase offset exists between a leading phase of the leading phase sample and a lagging phase of the lagging phase sample.

In accordance with at least one embodiment, the ground potential comprises a direct current (DC) and alternating current (AC) ground potential. In accordance with at least one embodiment, the first analog switch comprises a first field effect transistor (FET) having a first FET source terminal, a first FET drain terminal, and a first FET gate terminal. The first FET source terminal is coupled to the first operational amplifier input. The first FET source terminal is maintained continually at the ground potential.

In accordance with at least one embodiment, the first leading phase operational amplifier input of the leading phase operational amplifier subsystem comprises a leading phase inverting input. In accordance with at least one embodiment, the leading phase operational amplifier subsystem comprises a second leading phase operational amplifier input. The second leading phase operational amplifier input comprises a leading phase non-inverting input. The leading phase non-inverting input is coupled to the ground potential.

In accordance with at least one embodiment, the leading phase operational amplifier subsystem comprises a leading phase dual power supply operational amplifier subsystem having a positive supply voltage and a negative supply voltage. The ground potential is at a ground potential voltage that lies between the positive supply voltage and the negative supply voltage and is different from the positive supply voltage and is different from the negative supply voltage.

In accordance with at least one embodiment, the leading phase operational amplifier subsystem comprises a leading phase common mode input. The leading phase common mode input is coupled to the ground potential. In accordance with at least one embodiment, the leading phase operational amplifier subsystem comprises a leading phase fully differential operational amplifier.

In accordance with at least one embodiment, the apparatus further comprises a differential capacitor having a first differential capacitor terminal coupled to a first input of the leading phase fully differential operational amplifier and a second differential capacitor terminal coupled to a second input of the leading phase fully differential operational amplifier. In accordance with at least one embodiment, a local oscillator is coupled to the first analog switch to control switching of the first analog switch, wherein the local oscillator is referenced to ground potential.

In accordance with at least one embodiment, the leading phase operational amplifier subsystem comprises a leading phase capacitor in a leading phase capacitive feedback loop between a leading phase operational amplifier output of the leading phase operational amplifier subsystem and the first leading phase operational amplifier input; a leading phase feedback resistor in a leading phase resistive feedback loop between the leading phase operational amplifier output of the leading phase operational amplifier subsystem and the first leading phase operational amplifier input; and a leading phase resistor feedback switch. The leading phase resistor feedback switch is in series with the leading phase feedback resistor. The leading phase resistor feedback switch is in the leading phase resistive feedback loop. In accordance with at least one embodiment, the leading phase resistor feedback switch and the leading phase feedback resistor together are in parallel with the leading phase capacitor. In accordance with at least one embodiment, the first analog switch (e.g., an input switch) is located within the leading phase resistive feedback loop.

In accordance with at least one embodiment, the leading phase resistor feedback switch is responsive to a leading phase resistor feedback switch control signal operating in concert with a first analog switch control signal applied to a first analog switch control terminal of the first analog switch such that the leading phase resistor feedback switch and the first analog switch are adapted to be on only during a sampling period. In accordance with at least one embodiment, synchronous operation of the leading phase resistor feedback switch responsive to a leading phase resistor feedback switch control signal and a first input switch (e.g., a first analog switch) responsive to a first analog switch control signal applied to a first analog switch control terminal of the first analog switch (i.e., the leading phase resistor feedback switch operating synchronously with the first analog switch) beneficially allows coordinated sampling and holding of a sample of the input signal based on an input sampling clock. In accordance with at least one embodiment, phase coherent operation of the leading phase resistor feedback switch and a first input switch (e.g., a first analog switch) maximizes the efficiency of the phase sampling detector. In accordance with at least one embodiment, the first analog switch comprises a first analog switch input terminal. The first analog switch selectively couples the first analog switch input terminal to the first analog switch output terminal in response to the first analog switch control signal applied to the first analog switch control terminal. The first analog switch input terminal is coupled to an output first impedance matching resistor terminal of a first impedance matching resistor. The input first impedance matching resistor terminal of the first impedance matching resistor is coupled to a first winding terminal of an impedance matching transformer. In accordance with at least one embodiment, no direct current (DC) bias is applied to the impedance matching transformer. Accordingly, as an example, any alternating current (AC) signal provided by a secondary winding of the impedance matching transformer may remain purely AC (i.e., without being offset by a DC component). In accordance with at least one embodiment, no direct current (DC) bias is applied to the first analog switch input terminal and no direct current (DC) bias is applied to the first analog switch output terminal. Accordingly, as an example, any alternating current (AC) signal provided to the first analog switch input terminal may remain purely AC without being offset by a DC component. Accordingly, as another example, any alternating current (AC) signal present at the first analog switch output terminal may remain purely AC (i.e., without being offset by a DC component).

In accordance with at least one embodiment, the leading phase sample is selected from a group consisting of an I (In-phase) sample and a Q (Quadrature) sample. When the leading phase sample is the I sample, the lagging phase sample is the Q sample, and, when the leading phase sample is the Q sample, the lagging phase sample is the I sample.

In accordance with at least one embodiment, the phase sampling detector is implemented in an integrated circuit. At least one component is provided external to the integrated circuit. The at least one component is selected from a group consisting of: (1) a first differential capacitor having a first differential capacitor first terminal coupled to the first leading phase operational amplifier input and a first differential capacitor second terminal coupled to a differentially opposite leading phase operational amplifier input of the leading phase operational amplifier subsystem; (2) a second differential capacitor having a second differential capacitor first terminal coupled to the first lagging phase operational amplifier input and a second differential capacitor second terminal coupled to a differentially opposite lagging phase operational amplifier input of the lagging phase operational amplifier subsystem; (3) a leading phase capacitor having a first leading phase capacitor terminal coupled to a leading phase operational amplifier output of the leading phase operational amplifier subsystem and a second leading phase capacitor terminal coupled to the first leading phase operational amplifier input; and (4) a lagging phase capacitor having a first lagging phase capacitor terminal coupled to a lagging phase operational amplifier output of the lagging phase operational amplifier subsystem and a second lagging phase capacitor terminal coupled to the first lagging phase operational amplifier input.

In accordance with at least one embodiment, a phase sampling detector comprises a leading phase operational amplifier subsystem, a first analog switch having a first analog switch output terminal coupled to a first leading phase operational amplifier input of the leading phase operational amplifier subsystem, a lagging phase operational amplifier subsystem, and a second analog switch having a second analog switch output terminal coupled to a first lagging phase operational amplifier input of the lagging phase operational amplifier subsystem, wherein the leading phase operational amplifier subsystem is adapted to obtain a leading phase sample and the lagging phase operational amplifier subsystem is adapted to obtain a lagging phase sample, wherein a nonzero phase offset exists between a leading phase of the leading phase sample and a lagging phase of the lagging phase sample. The leading phase operational amplifier subsystem comprises a leading phase feedback resistor in a leading phase resistive feedback loop between the leading phase operational amplifier output of the leading phase operational amplifier subsystem and the first leading phase operational amplifier input, and a leading phase resistor feedback switch, wherein the leading phase resistor feedback switch is in series with the leading phase feedback resistor in the leading phase resistive feedback loop.

In accordance with at least one embodiment, the apparatus further comprises a leading phase capacitor in a leading phase capacitive feedback loop between a leading phase operational amplifier output of the leading phase operational amplifier subsystem and the first leading phase operational amplifier input. In accordance with at least one embodiment, the first analog switch is in series with the leading phase resistor feedback switch and the leading phase feedback resistor within the leading phase resistive feedback loop.

In accordance with at least one embodiment, apparatus comprises a phase sampling detector. The phase sampling detector comprises a leading phase operational amplifier subsystem, a first analog switch having a first analog switch output terminal coupled to a first leading phase operational amplifier input of the leading phase operational amplifier subsystem, a lagging phase operational amplifier subsystem; and a second analog switch having a second analog switch output terminal coupled to a first lagging phase operational amplifier input of the lagging phase operational amplifier subsystem, wherein the leading phase operational amplifier subsystem is adapted to obtain a leading phase sample and the lagging phase operational amplifier subsystem is adapted to obtain a lagging phase sample, wherein a nonzero phase offset exists between a leading phase of the leading phase sample and a lagging phase of the lagging phase sample. The first analog switch is located within a leading phase resistive feedback loop between a leading phase operational amplifier output of the leading phase operational amplifier subsystem and the first leading phase operational amplifier input.

In accordance with at least one embodiment, apparatus comprises a phase sampling detector. The phase sampling detector comprises a leading phase differential operational amplifier subsystem, a first analog switch having a first analog switch output terminal coupled to a first leading phase differential operational amplifier input of the leading phase differential operational amplifier subsystem, a first differential capacitor having a first differential capacitor first terminal coupled to the first leading phase differential operational amplifier input and a first differential capacitor second terminal coupled to a second leading phase differential operational amplifier input of the leading phase differential operational amplifier subsystem, a lagging phase differential operational amplifier subsystem; and a second analog switch having a second analog switch output terminal coupled to a first lagging phase differential operational amplifier input of the lagging phase differential operational amplifier subsystem, wherein the leading phase differential operational amplifier subsystem is adapted to obtain a leading phase sample and the lagging phase differential operational amplifier subsystem is adapted to obtain a lagging phase sample, wherein a nonzero phase offset exists between a leading phase of the leading phase sample and a lagging phase of the lagging phase sample.

In accordance with at least one embodiment, apparatus comprises a phase sampling detector. The phase sampling detector comprises a leading phase operational amplifier subsystem, a first analog switch having a first analog switch input terminal and having a first analog switch output terminal coupled to a first leading phase operational amplifier input of the leading phase operational amplifier subsystem, a lagging phase operational amplifier subsystem, and a second analog switch having a second analog switch output terminal coupled to a first lagging phase operational amplifier input of the lagging phase operational amplifier subsystem, wherein the leading phase operational amplifier subsystem is adapted to obtain a leading phase sample and the lagging phase operational amplifier subsystem is adapted to obtain a lagging phase sample, wherein a nonzero phase offset exists between a leading phase of the leading phase sample and a lagging phase of the lagging phase sample, wherein no direct current (DC) bias is applied to the first analog switch input terminal and no direct current (DC) bias is applied to the first analog switch output terminal.

In accordance with at least one embodiment, an apparatus comprises a phase sampling detector. The phase sampling detector comprises an element selected from a group consisting of: (1) a leading phase analog switch output terminal coupled to a first leading phase operational amplifier input and maintained continually at a ground potential, (2) a resistor feedback switch, (3) an input switch in a resistive feedback loop, (4) a differential capacitor, (5) an unbiased analog switch input terminal, and (6) an unbiased analog switch output terminal.

Although the invention has been described using certain specific examples, it will be apparent to those skilled in the art that the invention is not limited to these few examples. For example, the disclosure is discussed herein primarily with regard to quadrature sampling detectors, the invention is applicable to other types of detectors, including phase switching detectors having non-quadrature sampling phase angles as well. Additionally, various types of switching devices, amplifiers, as well as components for configuring amplifier gain and response are currently available which could be suitable for use in implementing apparatus as taught herein. Note also, that although an embodiment of the present invention has been shown and described in detail herein, along with certain variants thereof, many other varied embodiments that incorporate the teachings of the invention may be easily constructed by those skilled in the art. Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. Accordingly, the present invention is not intended to be limited to the specific form set forth herein, but on the contrary, it is intended to cover such alternatives, modifications, and equivalents, as can be reasonably included within the spirit and scope of the invention.

## Claims

1. Apparatus comprising:
a phase sampling detector comprising:
a leading phase operational amplifier subsystem;
a first analog switch having a first analog switch output terminal coupled to a first leading phase operational amplifier input of the leading phase operational amplifier subsystem, the first analog switch output terminal being maintained continually at a ground potential;
a lagging phase operational amplifier subsystem; and
a second analog switch having a second analog switch output terminal coupled to a first lagging phase operational amplifier input of the lagging phase operational amplifier subsystem, the second analog switch output terminal being maintained continually at the ground potential, wherein the leading phase operational amplifier subsystem is adapted to obtain a leading phase sample and the lagging phase operational amplifier subsystem is adapted to obtain a lagging phase sample, wherein a nonzero phase offset exists between a leading phase of the leading phase sample and a lagging phase of the lagging phase sample.

2. The apparatus of claim 1 wherein the ground potential comprises:
a direct current (DC) and alternating current (AC) ground potential.

3. The apparatus of claim 1 or 2 wherein the first analog switch comprises:
a first field effect transistor (FET) having a first FET source terminal, a first FET drain terminal, and a first FET gate terminal, the first FET source terminal coupled to the first operational amplifier input, the first FET source terminal being maintained continually at the ground potential.

4. The apparatus of one of the preceding claims wherein the first leading phase operational amplifier input of the leading phase operational amplifier subsystem comprises:
a leading phase inverting input, wherein the leading phase operational amplifier subsystem comprises:
a second leading phase operational amplifier input, wherein the second leading phase operational amplifier input comprises:
a leading phase non-inverting input, wherein the leading phase non-inverting input is coupled to the ground potential.

5. The apparatus of one of the preceding claims wherein the leading phase operational amplifier subsystem comprises:
a leading phase dual power supply operational amplifier subsystem having a positive supply voltage and a negative supply voltage, wherein the ground potential is at a ground potential voltage that lies between the positive supply voltage and the negative supply voltage and is different from the positive supply voltage and is different from the negative supply voltage.

6. The apparatus of one of the preceding claims wherein the leading phase operational amplifier subsystem comprises:
a leading phase common mode input, wherein the leading phase common mode input is coupled to the ground potential, and
a leading phase differential operational amplifier, and
a differential capacitor having a first differential capacitor terminal coupled to a first input of the leading phase differential operational amplifier and a second differential capacitor terminal coupled to a second input of the leading phase differential operational amplifier.

7. The apparatus of claim 1 further comprising:
an input sampling clock is coupled to the first analog switch to control switching of the first analog switch, wherein the input sampling clock is referenced to ground potential.

8. The apparatus of one of the preceding claims wherein the leading phase operational amplifier subsystem comprises:
a leading phase capacitor in a leading phase capacitive feedback loop between a leading phase operational amplifier output of the leading phase operational amplifier subsystem and the first leading phase operational amplifier input;
a leading phase feedback resistor in a leading phase resistive feedback loop between the leading phase operational amplifier output of the leading phase operational amplifier subsystem and the first leading phase operational amplifier input; and a leading phase resistor feedback switch, wherein the leading phase resistor feedback switch is in series with the leading phase feedback resistor in the leading phase resistive feedback loop, in particular when the leading phase resistor feedback switch is responsive to a leading phase resistor feedback switch control signal operating in concert with a first analog switch control signal applied to a first analog switch control terminal of the first analog switch such that the leading phase resistor feedback switch and the first analog switch are adapted to be on only during a sampling period

9. The apparatus of claim 8 wherein the first analog switch is located within the leading phase resistive feedback loop.

10. The apparatus of one of the preceding claims wherein the first analog switch comprises:
a first analog switch input terminal, wherein the first analog switch selectively couples the first analog switch input terminal to the first analog switch output terminal in response to the first analog switch control signal applied to the first analog switch control terminal, wherein the first analog switch input terminal is coupled to an output first impedance matching resistor terminal of a first impedance matching resistor, in particular when no direct current (DC) bias is applied to the first analog switch input terminal and no direct current (DC) bias is applied to the first analog switch output terminal.

11. The apparatus of one of the preceding claims wherein the leading phase sample is selected from a group consisting of an I (In-phase) sample and a Q (Quadrature) sample, wherein, when the leading phase sample is the I sample, the lagging phase sample is the Q sample, and, when the leading phase sample is the Q sample, the lagging phase sample is the I sample.

12. The apparatus of one of the preceding claims wherein the phase sampling detector is implemented in an integrated circuit, wherein at least one component is provided external to the integrated circuit, wherein the at least one component is selected from a group consisting of:
a first differential capacitor having a first differential capacitor first terminal coupled to the first leading phase operational amplifier input and a first differential capacitor second terminal coupled to a differentially opposite leading phase operational amplifier input of the leading phase operational amplifier subsystem;
a second differential capacitor having a second differential capacitor first terminal coupled to the first lagging phase operational amplifier input and a second differential capacitor second terminal coupled to a differentially opposite lagging phase operational amplifier input of the lagging phase operational amplifier subsystem;
a leading phase capacitor having a first leading phase capacitor terminal coupled to a leading phase operational amplifier output of the leading phase operational amplifier subsystem and a second leading phase capacitor terminal coupled to the first leading phase operational amplifier input; and
a lagging phase capacitor having a first lagging phase capacitor terminal coupled to a lagging phase operational amplifier output of the lagging phase operational amplifier subsystem and a second lagging phase capacitor terminal coupled to the first lagging phase operational amplifier input.

13. Apparatus comprising:
a phase sampling detector comprising:
a leading phase operational amplifier subsystem;
a first analog switch having a first analog switch output terminal coupled to a first leading phase operational amplifier input of the leading phase operational amplifier subsystem;
a lagging phase operational amplifier subsystem; and
a second analog switch having a second analog switch output terminal coupled to a first lagging phase operational amplifier input of the lagging phase operational amplifier subsystem, wherein the leading phase operational amplifier subsystem is adapted to obtain a leading phase sample and the lagging phase operational amplifier subsystem is adapted to obtain a lagging phase sample,
wherein a nonzero phase offset exists between a leading phase of the leading phase sample and a lagging phase of the lagging phase sample, wherein the leading phase operational amplifier subsystem comprises:
a leading phase feedback resistor in a leading phase resistive feedback loop between the leading phase operational amplifier output of the leading phase operational amplifier subsystem and the first leading phase operational amplifier input; and
a leading phase resistor feedback switch, wherein the leading phase resistor feedback switch is in series with the leading phase feedback resistor in the leading phase resistive feedback loop.

14. The apparatus of claim 13 further comprising:
a leading phase capacitor in a leading phase capacitive feedback loop between a leading phase operational amplifier output of the leading phase operational amplifier subsystem and the first leading phase operational amplifier input.

15. The apparatus of claim 13 or 14 wherein the first analog switch is in series with the leading phase resistor feedback switch and the leading phase feedback resistor within the leading phase resistive feedback loop.
